# EUROPEAN PATENT APPLICATION

(11) **EP 3 872 444 A1**
(43) Date of publication of application: **01.09.2021**
(21) Application number: 20159279.7
(22) Date of filing: 25.02.2020
(51) Int. Cl.: G01B 9/02, G01B 11/00, G03F 7/20

(54) **INTERFEROMETER SYSTEM AND LITHOGRAPHIC APPARATUS**

(71) Applicant: ASML Netherlands B.V., 5500 AH Veldhoven (NL)
(72) Inventor: LIEDECKE, Christian, 5500 AH Veldhoven (NL); BAGGEN, Marcel Koenraad Marie, 5500 AH Veldhoven (NL); JANSEN, Maarten Jozef, 5500 AH Veldhoven (NL); MRIDHA, Manoj Kumar, 5500 AH Veldhoven (NL)
(74) Representative: ASML Netherlands B.V.

(57) **Abstract**

The invention relates to an interferometer system comprising a light source to provide a radiation beam, an optical fiber, and an optical unit arranged on an object of interest comprising a fiber end holding device to hold a measurement end of the optical fiber, and a reflector arranged on the object of interest.

The measurement end of the optical fiber being arranged to partially transmit and partially reflect the radiation beam to split the radiation beam in a measurement beam and a reference beam, the optical unit is arranged to direct the measurement beam to a reflective surface on the reference object, the reflector is arranged to reflect the measurement beam after reflection on the reflective surface back to the reflective surface, the optical unit is arranged to receive the reflected measurement beam and guide the reflected measurement beam to the end surface.

## Description

### FIELD

The present invention relates to an interferometer system and a lithographic apparatus comprising the interferometer system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In a lithographic apparatus, interferometer systems may be used to determine a displacement between an object of interest and a reference object. Some embodiments of these interferometer systems only need to measure the displacement over a relative small range of movement.

In a known embodiment of such interferometer system, the interferometer system comprises an optical unit mounted on an object of interest and constructed to direct a measurement beam towards a corner cube mounted on the reference object. The measurement beam is reflected by the corner cube back to the optical unit. In the optical unit, the measurement beam is recombined with a reference beam to provide a recombined beam. By processing of a detector signal obtained from this recombined beam a displacement of the object of interest with respect to the reference object can be determined.

A drawback of this embodiment is that the interferometer system requires that a corner cube is mounted on the reference object. In some applications there may be little space available for such corner cube on the reference object. For example, in an interferometer system for measurement of displacement of a cooling hood with respect to a metro frame, an object mounted on the metro frame may be used as reference object. Such reference object is for instance a Z-mirror used as reference element in a position measurement system for a substrate stage. An attachment of the corner cube to this Z-mirror using an adhesive bond, or any other suitable attachment technique, implies a stability risk for the Z-mirror. This stability risk may result in incorrect position measurement of the substrate stage.

In addition, it may be required that the corner cube is arranged in a pocket hole in the Z-mirror to prevent that the corner cube extends from the Z-mirror. Such pocket hole also induces a risk on stability/strength of the Z-mirror.

Another drawback of the known embodiment of the interferometer system is that the interferometer layout may be sensitive to crosstalk from one direction to another orthogonal direction caused by beam tilt of the measurement beam propagating between the object of interest and the reference object. Theoretically, this measurement beam is perpendicular to the other direction, but in practice the measurement beam is not perfectly aligned. This results in a beam tilt of the measurement beam with respect to the theoretical measurement direction.

To reduce this cross talk, the beam tilt may need adjustment to values lower than about 0.2 mRad. This implies a considerable impact during construction and configuration of the interferometer system in the lithographic apparatus. Moreover, the adjustment might need to be repeated when there are changes in the position of the object of interest.

### SUMMARY

It is an object of the invention to provide an interferometer system of simple construction that can be used to determine displacement of an object of interest with respect to a reference object. It is a further object of the invention to provide an interferometer system which may be used with low impact on the construction of at least one of the object of interest and the reference object. It is another object of the invention to provide an interferometer system which is less sensitive to cross talk than the known embodiment of an interferometer system.

According to an embodiment of a first aspect of the invention, there is provided an interferometer system to determine a displacement of an object of interest with respect to a reference object, comprising:
a light source to provide a radiation beam,
an optical fiber to guide the radiation beam from a source end adjacent to the light source to a measurement end,
   an optical unit arranged on the object of interest comprising a fiber end holding device to hold the measurement end of the optical fiber, and
a retroreflector arranged on the object of interest,
wherein the measurement end of the optical fiber comprises an end surface arranged to partially transmit and partially reflect the radiation beam to split the radiation beam in a measurement beam transmitted by the end surface and a reference beam reflected by the end surface,
wherein the optical unit is arranged to direct the measurement beam to a reflective surface on the reference object, wherein the reflector is arranged to receive and reflect the measurement beam after reflection on the reflective surface back to the reflective surface, and wherein the optical unit is arranged to receive the reflected measurement beam and guide the reflected measurement beam at least partially to the end surface to form a recombined beam with the reference beam.

According to an embodiment of a first aspect of the invention, there is provide a lithographic apparatus comprising an interferometer system to determine a displacement of an object of interest with respect to a reference object, the interferometer system comprising:
a light source to provide a radiation beam,
an optical fiber to guide the radiation beam from a source end adjacent to the light source to a measurement end,
an optical unit arranged on the object of interest and comprising a fiber end holding device to hold the measurement end of the optical fiber, and
a reflector arranged on the object of interest,
wherein the measurement end of the optical fiber comprises an end surface arranged to partially transmit and partially reflect the radiation beam to split the radiation beam in a measurement beam transmitted by the end surface and a reference beam reflected by the end surface,
wherein the optical unit is arranged to direct the measurement beam to a reflective surface on the reference object, wherein the reflector is arranged to receive and reflect the measurement beam back to the reflective surface after reflection on the reflective surface, and wherein the optical unit is arranged to receive the reflected measurement beam and guide the reflected measurement beam at least partially to the end surface to form a recombined beam with the reference beam.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a detailed view of a part of the lithographic apparatus of Figure 1;
- Figure 3 schematically depicts a position control system;
- Figure 4 schematically depicts an embodiment of an interferometer system used in a lithographic apparatus;
- Figure 5 schematically depicts a first embodiment of an interferometer system according to the invention for use in a lithographic apparatus; and
- Figure 6 schematically depicts a second embodiment of an interferometer system according to the invention for use in a lithographic apparatus.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

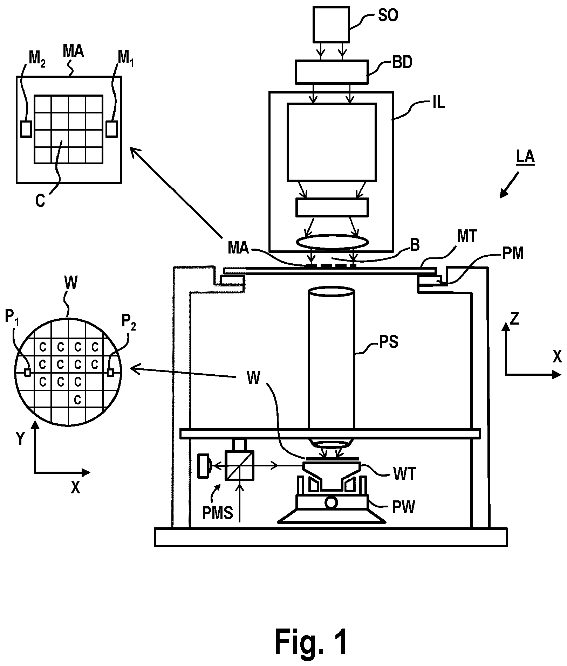

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system PMS, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

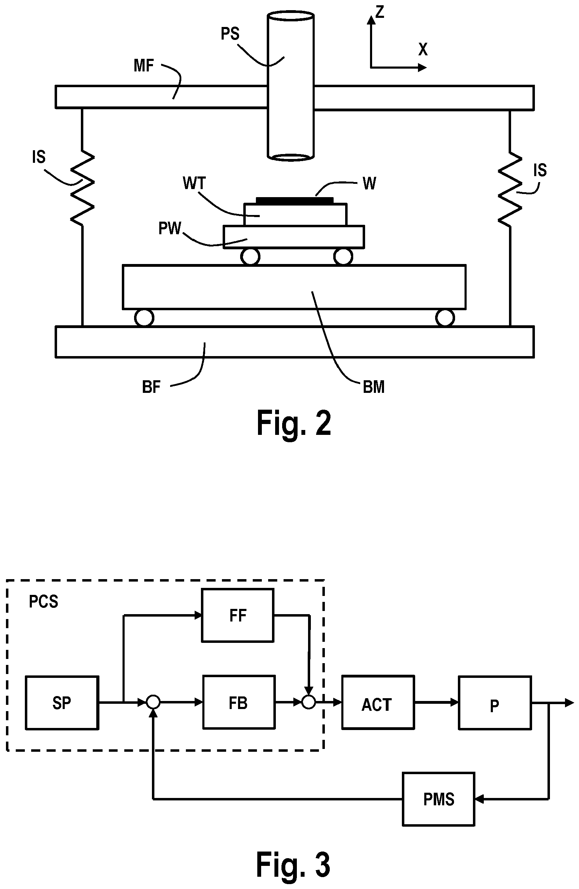

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example,+1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads are arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

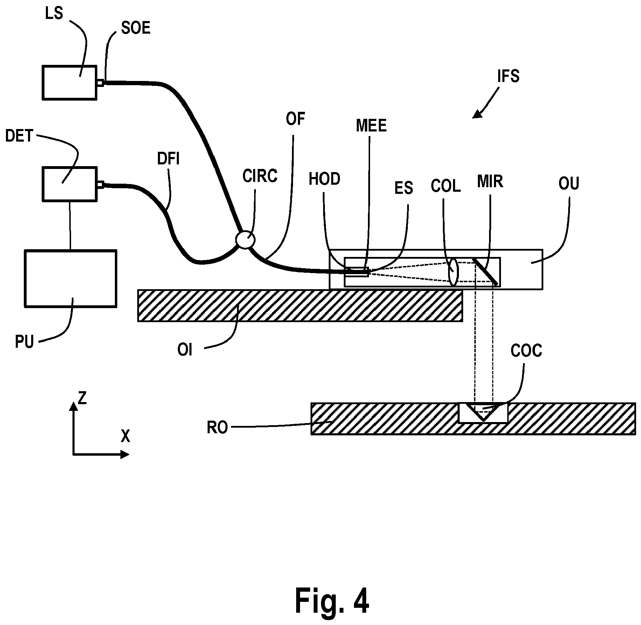

Figure 4 shows an embodiment of an interferometer system IFS arranged to determine a displacement of an object of interest OI with respect to a reference object RO.

The interferometer system IFS comprises a light source LS, for example a laser source, to provide a radiation beam. This radiation beam is guided into a source end SOE of an optical fiber OF adjacent the light source LS. The optical fiber OF guides the radiation beam to a measurement end MEE of the optical fiber OF. The measurement end MEE of the optical fiber OF is held by a fiber end holding device HOD. The fiber end holding device HOD is part of an optical unit OU mounted on the object of interest OI.

At the measurement end MEE, the optical fiber OF comprises an end surface ES. The end surface ES is a semi-transparent surface arranged to partially transmit and partially reflect the radiation beam to split the radiation beam in a measurement beam transmitted by the end surface ES and a reference beam reflected by the end surface ES.

The optical unit OU comprises the fiber end holding device HOD, a collimator lens COL and a mirror MIR. The measurement beam which leaves the optical fiber OF at the end surface ES will be projected by the collimator lens COL on the mirror MIR. The mirror MIR will change the propagation direction of the measurement beam from the x-direction to the z-direction to direct the measurement beam towards the reference object RO.

On the reference object RO, in a sensor pocket, a corner cube COC is mounted which reflects the measurement beam in substantially the same direction as the direction in which the measurement beam is directed on the corner cube COC. The reflected measurement beam is received by the mirror MIR which guides the reflected measurement beam back through the collimator lens COL at least partially on the end surface ES of the optical fiber OF.

At the end surface ES the reflected measurement beam will be partially transmitted by the end surface ES and re-enter the optical fiber OF. In the optical fiber OF the reflected measurement beam will be recombined with the reference beam reflected on the end surface ES to form a recombined beam.

At a circulator CIRC, the recombined beam will be guided into an optical detector fiber DFI which will guide the recombined beam to a light detector DET. The light detector DET will receive the recombined beam and provide a detector signal on the basis of the received recombined beam to a processing unit PU to process the detector signal. By processing of the detector signal in the processing unit PU, a displacement of the object of interest OI with respect to the reference object RO may be determined. The determination of the displacement is based on interference between the reflected measurement beam and the reflected reference beam of the recombined beam.

The embodiment of Figure 4 has some drawbacks. A first drawback of this embodiment is that the interferometer system IFS requires that a corner cube COC is mounted on the reference object RO. In some applications there may be little space available for such corner cube COC. For example, in an interferometer system IFS for measurement of displacement of a cooling hood with respect to a metro frame, an object mounted on the metro frame may be used as a reference object. Such object mounted on the metro frame is for instance a Z-mirror for the substrate stage, i.e. a reference element for measurement of a z-position of a substrate stage in the lithographic apparatus. An attachment of the corner cube COC to this Z-mirror using an adhesive bond, or other suitable attachment technique, implies a stability risk for this Z-mirror and therefore may result in incorrect position measurement of the substrate stage.

In addition, it may be required to arrange the corner cube COC in a pocket hole in the Z-mirror, as shown in Figure 4, to prevent that the corner cube extends from the Z-mirror. This pocket hole may induce a further risk on stability/strength of the Z-mirror. Also, the positioning accuracy of the corner cube COC should remain within the size of the measurement beam of the interferometer system IFS. This may also add positioning/adjustment requirements across different applications.

Another drawback of the interferometer system IFS of Figure 4 is that the interferometer layout may be sensitive to crosstalk from x/y-direction to z-direction because of the effect of beam tilt of the measurement beam of the interferometer system propagating between the object of interest OI and the reference object RO. Theoretically, this measurement beam is perpendicular to the other direction, but in practice the measurement beam is not perfectly aligned. This results in a beam tilt of the measurement beam with respect to the theoretical measurement direction, and this beam tilt may result in cross-talk.

When the object of interest OI, for instance a cooling hood, is mounted onto the base frame, and the corner cube COC is attached to the Z-mirror mounted on the metro frame, a relative motion in x/y-direction may lead to measuring errors in Z-direction due to the beam tilt. To reduce this cross talk, the beam tilt may need adjustment to values lower than about 0.2 mRad. This implies a considerable impact during construction and configuration of the interferometer system IFS in the lithographic apparatus. Moreover, the adjustment might need to be repeated when there are changes in the position of the object of interest OI.

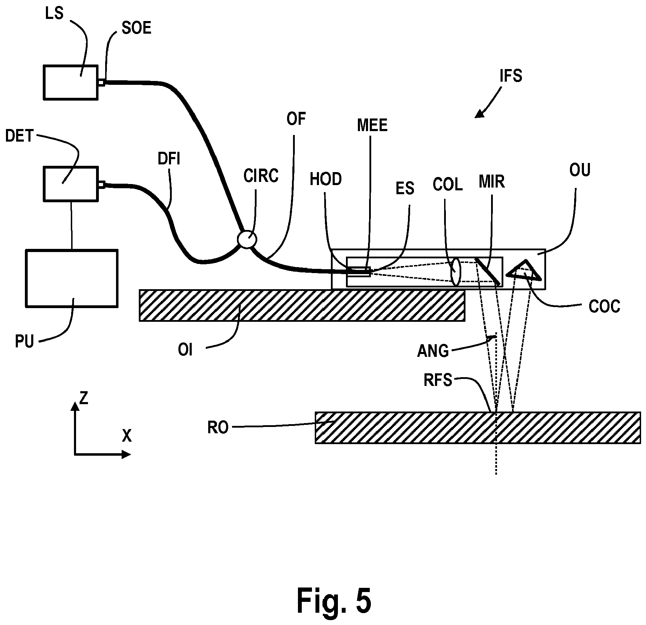

Figure 5 schematically depicts a first embodiment of an interferometer system IFS according to the invention. The light source LS, the light detector DET and the processing unit PU may be substantially the same as the light source LS, the light detector DET and the processing unit PU of the embodiment of Figure 4.

The light source LS, for example a laser source, is arranged to provide a radiation beam. This radiation beam is guided into a source end SOE of an optical fiber OF adjacent to the light source LS. The optical fiber OF guides the radiation beam to a measurement end MEE of the optical fiber OF. The measurement end MEE of the optical fiber OF is held by a fiber end holding device HOD. The fiber end holding device HOD is part of an optical unit OU mounted on the object of interest OI.

At the measurement end MEE, the optical fiber comprises an end surface ES. The end surface is a semi-transparent surface arranged to partially transmit and partially reflect the radiation beam to split the radiation beam in a measurement beam transmitted by the end surface ES and a reference beam reflected by the end surface ES back into the optical fiber OF.

The optical unit OU comprises the fiber end holding device HOD, a collimator lens COL, a mirror MIR and a corner cube COC. The advantage of this optical unit OU is that the fiber end holding device HOD, the collimator lens COL, the mirror MIR and the corner cube COC have a fixed positional relationship with respect to each other. On the reference object RO only a flat reflective surface RFS is provided which reflects any beam directed to the reflective surface RFS. The reflective surface RFS is for example a reflective coating.

The angle of the mirror MIR is selected such that a light beam directed at an angle towards the reflective surface RFS will be received by the corner cube COC after reflection of the measurement beam on the reflective surface RFS.

The measurement beam that leaves the optical fiber OF at the end surface ES will be projected by the collimator lens COL onto the mirror MIR to change the propagation direction of the measurement beam from the x-direction to an angled direction in which the measurement beam is directed towards the reflective surface RFS on the reference object RO. The angled direction in which the measurement beam is directed towards the reflective surface RFS direction may have an angle ANG in the range of 5 to 30 degrees with respect to a direction perpendicular to the reflective surface RFS, for example 10 to 20 degrees, such as about 15 degrees with respect to a direction perpendicular to the reflective surface RFS.

The distance between the mirror MIR, the reflective surface RFS and the corner cube COC and the angle ANG of the measurement beam with respect to the reflective surface RFS is selected such that at the reflective surface the measurement beam will be reflected towards the corner cube COC. The corner cube COC will reflect the measurement beam back to the reflective surface RFS at the same angle as in which the corner cube COC receives the measurement beam. At the reflective surface RFS the reflected measurement beam is again reflected at angle ANG towards the mirror MIR.

The reflected measurement beam is received by the mirror MIR which guides the reflected measurement beam through the collimator lens COL at least partially on the end surface ES of the optical fiber OF.

At the end surface ES the reflected measurement beam will be partially transmitted by the end surface ES and re-enter the optical fiber OF. In the optical fiber OF the reflected measurement beam will be combined with the reference beam reflected on the end surface ES to form a recombined beam which is guided via a circulator CIRC to the light detector DET. The detector DET will provide a detector signal that can be processed by the processing unit PU.

The interferometer system IFS of the embodiment of Figure 5 has the advantage that interferometer system IFS only requires a reflective surface RFS on the reference object RO to enable a measurement on the basis of which displacement of the object of interest OI with respect to the reference object RO can be determined. The provision of such reflective surface RFS has a relatively low impact on the construction of the reference object RO.

Further, in the embodiment of Figure 5, any crosstalk between x-direction and measurement direction is not determined by the beam tilt of the measurement beam, but only by tilt of the reflective surface RFS. This tilt has less effect on the measurement and can more easily be determined and compensated when needed. Therefore, the interferometer system IFS of Figure 5 is less sensitive to cross talk. As a result, there are less strict requirements with respect to the construction and configuration of the interferometer system IFS.

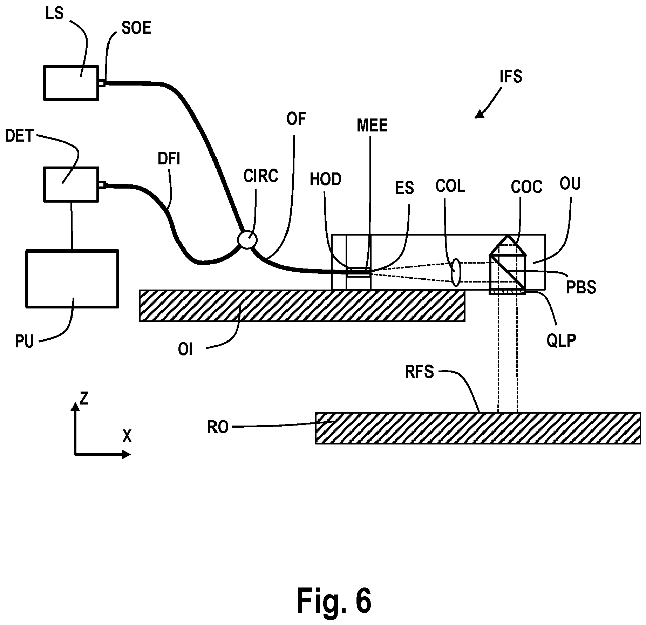

Figure 6 schematically depicts a second embodiment of an interferometer system IFS according to the invention for use in a lithographic apparatus.

The light source LS, for example a laser source, is arranged to provide a polarized radiation beam. This polarized radiation beam is guided by the optical fiber OF to an end surface ES at a measure end MEE of the optical fiber OF. The optical fiber OF is constructed to maintain the polarization of polarized radiation beam.

The measurement end MEE of the optical fiber OF is held by a fiber end holding device HOD. The fiber end holding device HOD is part of an optical unit OU mounted on the object of interest OI.

The end surface ES of the optical fiber OF is a semi-transparent surface arranged to partially transmit and partially reflect the radiation beam to split the radiation beam in a measurement beam transmitted by the end surface ES and a reference beam reflected by the end surface ES back into the optical fiber OF.

The optical unit OU comprises the fiber end holding device HOD, a collimator lens COL, a polarization beam splitter PBS, a quarter lambda plate QLP and a corner cube COC. On the reference object RO only a flat reflective surface RFS is provided which reflects any beam directed to the reflective surface RFS.

The angle of the polarization beam splitter PBS is selected such that the polarization beam splitter PBS will change the propagation direction of the polarized measurement beam from the x-direction to the z-direction to direct the measurement beam towards the reflective surface RFS on the reference object RO at a direction substantially perpendicular to the reflective surface RFS. At the reflective surface RFS the polarized measurement beam will be reflected back to the polarization beam splitter PBS arranged in the optical unit OU. While propagating from the optical unit OU on the object of interest OI to the reference object RO and back from the reference object RO to the polarization beam splitter PBS, the measurement beam passes the quarter lambda plate QLP twice. This changes the polarization of the measurement beam such that the polarized measurement beam will now be transmitted by the polarization beam splitter PBS towards the corner cube COC. The corner cube COC will reflect the polarized measurement beam so that the polarized measurement beam will again pass the polarization beam splitter PBS, the quarter lambda plate QLP and will be directed to the reflective surface RFS on the reference object RO. On the reflective surface RFS the polarized measurement beam will be reflected back to the polarization beam splitter PBS. The polarized measurement beam has again passed the quarter lambda plate QLP twice such that the polarization is changed back to the original polarization.

The reflected measurement beam is now reflected by the polarization beam splitter PBS and directed through the collimator lens COL at least partially on the end surface ES of the optical fiber OF.

At the end surface ES the reflected measurement will be at least partially be transmitted by the end surface ES and re-enter the optical fiber OF. In the optical fiber OF the reflected measurement beam will be combined with the reference beam reflected on the end surface ES to form a recombined beam. the recombined beam is guided by the circulator CIRC from the optical fiber OF to the detector fiber DFI. The light detector DET will receive the recombined beam and provide a detector signal on the basis of the received recombined beam to a processing unit PU to process the detector signal.

Corresponding to the embodiment of Figure 5, the interferometer system IFS of the embodiment of Figure 6 also only requires a reflective surface RFS on the reference object RO and the crosstalk is not dependent on the beam tilt of the measurement beam. This allows a less strict construction and configuration of the interferometer system IFS and has relatively low impact on the construction of the reference object RO.

A further advantage is that the interferometer system may function in a large range of distances between the reference object RO and the object of interest OI, since the measurement beam is propagated in z-direction between the reference object RO and the object of interest OI, i.e. perpendicular to the reflective surface RFS.

A drawback of the interferometer system IFS of the embodiment of Figure 6 compared with the embodiment of Figure 5 is that the embodiment of Figure 6 requires polarization elements configured to handle polarized beams, such as a light source LS providing a polarized measurement beam, optical fibers maintaining the polarization, the polarization beam splitter PBS, and the quarter lambda plate QLP. Generally, these polarization elements are more complex and expensive.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An interferometer system to determine a displacement of an object of interest with respect to a reference object, comprising:
a light source to provide a radiation beam,
an optical fiber to guide the radiation beam from a source end adjacent to the light source to a measurement end,
an optical unit arranged on the object of interest and comprising a fiber end holding device to hold the measurement end of the optical fiber, and
a reflector arranged on the object of interest,
wherein the measurement end of the optical fiber comprises an end surface arranged to partially transmit and partially reflect the radiation beam to split the radiation beam in a measurement beam transmitted by the end surface and a reference beam reflected by the end surface,
wherein the optical unit is arranged to direct the measurement beam to a reflective surface on the reference object, wherein the reflector is arranged to receive and reflect the measurement beam after reflection on the reflective surface back to the reflective surface, and wherein the optical unit is arranged to receive the reflected measurement beam and guide the reflected measurement beam at least partially to the end surface to form a recombined beam with the reference beam.

2. The interferometer system of claim 1, wherein the optical unit is arranged to direct the measurement beam at a non-perpendicular angle to the reflective surface.

3. The interferometer system of claim 1 or 2, wherein the reflector is arranged to reflect the radiation beam in the same direction as a direction in which the reflector receives the radiation beam.

4. The interferometer system of any of the preceding claims, wherein the reflector is comprised in the optical unit.

5. The interferometer system of any of the preceding claims, wherein the reflector is a corner cube.

6. The interferometer system of any of the preceding claims, wherein the interferometer system comprises a mirror arranged non-perpendicular with respect to the measurement beam in order to adapt a measurement direction of the measurement beam.

7. The interferometer system of any of the preceding claims, wherein the reflective surface on the reference object is a flat reflective surface.

8. The interferometer system of any of the preceding claims, wherein the interferometer system comprises:
a detector to receive the recombined beam and to provide a detector signal on the basis of the received recombined beam,
a processing unit to process the detector signal.

9. The interferometer system of any of the preceding claims, wherein the object of interest is mounted to a base frame of the lithographic apparatus and/or wherein the reference object is mounted to a metro frame of the lithographic apparatus.

10. The interferometer system of any of the preceding claims, wherein the interferometer system comprises a collimator lens.

11. The interferometer system of any of the preceding claims, wherein the measurement beam is a polarized beam, wherein the optical unit comprises a polarization beam splitter and a quarter lambda plate, wherein the measurement beam passes the quarter lambda plate each time the measurement beam is directed from the object of interest to the reference object and from the reference object to the object of interest.

12. A lithographic apparatus comprising an interferometer system to determine a displacement of an object of interest with respect to a reference object, the interferometer system comprising:
a light source to provide a radiation beam,
an optical fiber to guide the radiation beam from a source end adjacent to the light source to a measurement end,
an optical unit arranged on the object of interest comprising a fiber end holding device to hold the measurement end of the optical fiber, and
a reflector arranged on the object of interest,
wherein the measurement end of the optical fiber comprises an end surface arranged to partially transmit and partially reflect the radiation beam to split the radiation beam in a measurement beam transmitted by the end surface and a reference beam reflected by the end surface,
wherein the optical unit is arranged to direct the measurement beam to a reflective surface on the reference object, wherein the reflector is arranged to receive and reflect the measurement beam back to the reflective surface after reflection on the reflective surface, and wherein the optical unit is arranged to receive the reflected measurement beam and guide the reflected measurement beam at least partially to the end surface to form a recombined beam with the reference beam.

13. The lithographic apparatus of claim 12, wherein the optical unit is arranged to direct the measurement beam at a non-perpendicular angle to the reflective surface.

14. The lithographic apparatus of claim 12 or 13, wherein the object of interest is mounted to a base frame of the lithographic apparatus.

15. The lithographic apparatus of any of the claims 12-14, wherein the reference object is mounted to a metro frame of the lithographic apparatus.
